# FASCICULE DE BREVET EUROPEEN

(11) **EP 0 382 605 B1**
(45) Date de publication et mention de la délivrance du brevet: **06.10.1993**
(21) Numéro de dépôt: 90400278.9
(22) Date de dépôt: 02.02.1990
(51) Int. Cl.: H05K 13/06

(54) **Système pour la réalisation dans un plan d'une pièce de câblage**
Vorrichtung zur Darstellung eines Verdrahtungsstücks in einer Ebene
Device for depositing a piece of wiring in a plane

(30) Priorité: 07.02.1989 FR 8901541
(43) Date de publication de la demande: 16.08.1990
(73) Titulaire: AEROSPATIALE Société Nationale Industrielle, 75781 Paris Cédex 16 (FR)
(72) Inventeur: Cerda, Léon Germain, F-13620 Carry-le-Rouet (FR)
(74) Mandataire: Bonnetat, Christian

(56) Documents cités:
- DE-A- 3 125 449
- GB-A- 1 221 641
- GB-A- 2 014 775
- US-A- 2 805 471

## Description

La présente invention concerne un système pour la réalisation dans un plan d'une pièce de câblage comportant une pluralité de conducteurs ou de câbles dont chacun doit suivre un cheminement prédéterminé.

L'invention s'applique, plus particulièrement quoique non exclusivement, à la réalisation de pièces de câblage pour aéronefs, et notamment hélicoptères, dans lesquels lesdites pièces reliant entre eux les nombreux équipements électriques et électroniques nécessaires au pilotage desdits appareils et à l'exécution des différentes missions qu'ils doivent effectuer, sont très complexes et variées.

Avant d'installer lesdites pièces de câblage, par exemple dans un aéronef qu'elles doivent équiper, il est nécessaire de mettre en forme lesdites pièces, conformément à l'agencement interne de l'aéronef, sur de longues tables (jusqu'à une dizaine de mètres de longueur), chaque câble ou conducteur s'étendant, sur la table, entre des positions d'entrée et de sortie spécifiques, en suivant un cheminement prédéterminé.

Actuellement, les cheminements des différents conducteurs constituant la pièce de câblage sont représentés graphiquement sur une feuille de papier disposée sur la table, sous une plaque transparente munie d'une pluralité de trous destinés à recevoir des pions de guidage pour le maintien en place provisoire des conducteurs le long de leur cheminement.

Pour chaque conducteur à mettre en place, l'opérateur doit tout d'abord identifier celui-ci, puis, à l'aide d'une documentation technique, rechercher, parmi la pluralité de cheminements représentés, celui qui correspond au conducteur qu'il vient d'identifier. L'opérateur peut alors mettre en place le conducteur en suivant le tracé de son cheminement, et en l'y maintenant à l'aide de pions de guidage disposés, par l'opérateur, en des endroits appropriés du tracé. L'opérateur doit bien sûr recommencer cet ensemble d'opérations pour chaque conducteur de la pièce.

Un tel travail est bien évidemment fastidieux, et des erreurs sont quasiment inévitables, compte tenu, d'une part, de la longueur des tables et, d'autre part, du fait que la réalisation de telles pièces de câblage peut mettre en oeuvre plusieurs centaines de conducteurs. Même si un "canevas" de la pièce est représenté sur la table, l'opérateur se retrouve en fait devant un véritable "fouillis" de conducteurs entrelacés difficile à maîtriser.

Une methode pour situer les trajets de câbles sur une plaque de câblage est connue du US-A-2 805 471. D'après cette methode un projecteur de diapositives projette sur la plaque de câblage le trajet que le câble doit avoir sur la plaque.

La présente invention a pour but d'éviter ces inconvénients, et concerne un système permettant de réaliser à plat des pièces de câblage de façon plus simple et plus fiable.

A cet effet, le système pour la réalisation dans un plan d'une pièce de câblage, comportant une pluralité de conducteurs dont chacun doit suivre un cheminement prédéterminé, du type comportant :
- un support plan,
- des moyens de représentation de chacun desdits cheminements sur ledit support, et
- des moyens de maintien en place provisoire desdits conducteurs le long de leur cheminement, est remarquable, selon l'invention, en ce que lesdits moyens de représentation comprennent un générateur d'un faisceau de lumière cohérente, pour lequel ledit support plan joue le rôle d'écran, susceptible de balayer ledit support plan de façon à afficher, sur celui-ci, le tracé lumineux du cheminement d'un conducteur déterminé de ladite pièce, et en ce que ledit système comporte de plus des moyens pour mémoriser les informations relatives aux cheminements des différents conducteurs de la pièce de câblage, reliés, d'une part, à des moyens d'identification d'un conducteur déterminé et, d'autre part, à des moyens pour commander ledit générateur de faisceau pour afficher, sur ledit support, le cheminement spécifique audit conducteur déterminé.

Ainsi, grâce au système de l'invention, l'opérateur dispose, de façon automatisée, de toutes les informations nécessaires à la réalisation, conducteur par conducteur, d'une pièce de câblage (identification d'un conducteur déterminé et affichage du tracé de son cheminement).

Avantageusement, ledit faisceau balaye ledit support à une vitesse suffisamment grande pour obtenir une persistance optique dudit tracé.

Par ailleurs, dans le cas où, de façon connue, lesdits moyens de maintien en place provisoire des conducteurs sont constitués de pions de guidage destinés à être insérés dans des trous prévus dans une plaque transparente recouvrant ledit support plan, selon l'invention ledit générateur peut être commandé de façon que ledit faisceau désigne successivement une série déterminée de trous, dans lesquels doivent être insérés lesdits pions, en constituant ainsi une ébauche de cheminement pour chacun desdits conducteurs.

Selon une autre caractéristique de l'invention, lesdits moyens d'identification sont constitués par un lecteur de codes à barres.

Selon encore une autre caractéristique de l'invention, ledit générateur est un générateur à laser de faible puissance.

Les figures du dessin annexé feront bien comprendre comment l'invention peut être réalisée.

La figure 1 illustre schématiquement le système pour la réalisation à plat d'une pièce de câblage selon l'invention.

Les figures 2a à 2f sont des vues de face partielles, à plus grande échelle, du support plan recouvert d'une plaque transparente, utilisé dans le système de l'invention, illustrant les différentes étapes de la réalisation d'une pièce de câblage.

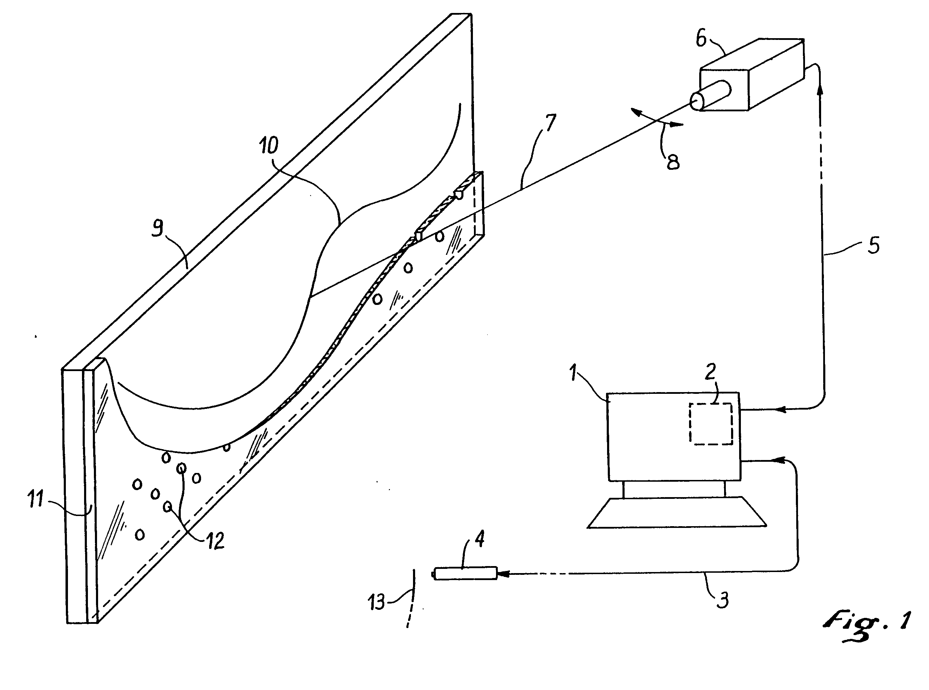

En se référant à la figure 1, le système de l'invention comprend un micro-ordinateur 1, comportant une mémoire 2 des informations relatives aux cheminements des différents conducteurs de la pièce de câblage, relié, par une liaison 3, à un lecteur de codes à barres 4 permettant l'identification de chacun des conducteurs de ladite pièce et, par une liaison 5, à un générateur 6 susceptible d'émettre un faisceau laser 7 de faible puissance.

Un conducteur déterminé 13 ayant été identifié grâce au lecteur 4, conducteur pour lequel les informations concernant son cheminement spécifique sont stockées dans la mémoire 2, le processeur du micro-ordinateur 1 est adapté pour piloter le générateur 6 de sorte que le faisceau laser 7 balaye (double flèche 8) le support plan 9 de façon à afficher, sur ledit support jouant le rôle d'écran, le tracé lumineux 10 du cheminement dudit conducteur. La vitesse de balayage du faisceau laser 7 est suffisamment grande pour obtenir une persistance optique dudit tracé 10.

Par ailleurs, une plaque transparente 11 recouvre le support 9 et est munie d'une pluralité de trous 12, disposés, par exemple, en lignes et colonnes agencées en quinconce, chacun desdits trous 12 étant susceptible de recevoir un pion de guidage permettant le maintien en place provisoire des conducteurs, comme cela sera expliqué plus en détail ci-après en référence aux figures 2a à 2f.

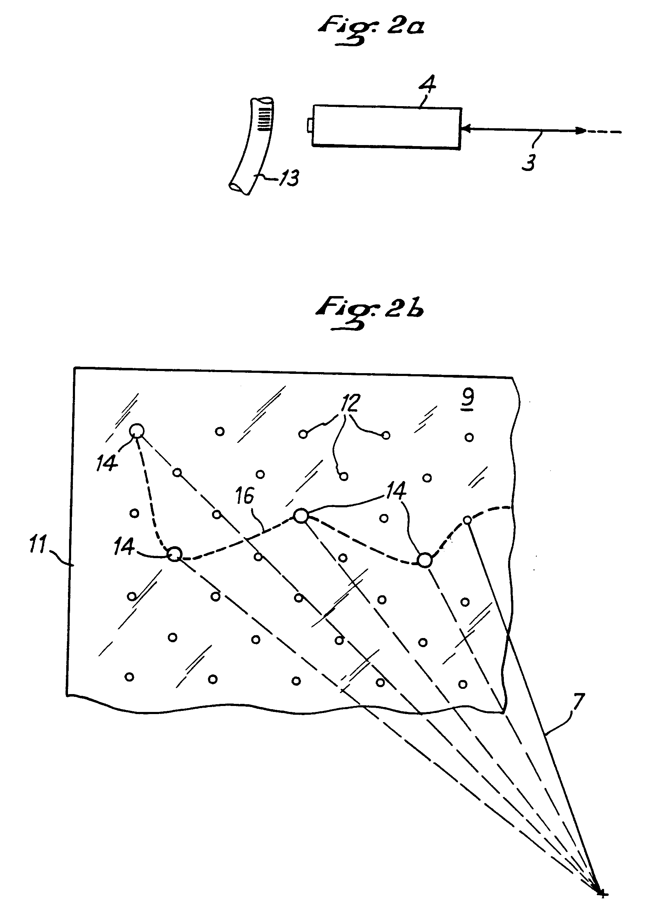

En effet, après identification du conducteur 13 par le lecteur de codes à barres 4 (figure 2a) et préalablement à la mise en place dudit conducteur, le générateur peut être commandé de façon que le faisceau 7 désigne successivement une série déterminée de trous 12, dans lesquels l'opérateur insère, à chaque fois, un pion de guidage 14, en obtenant ainsi, en définitive, une ébauche 16 du cheminement pour ledit conducteur (en traits interrompus sur la figure 2b).

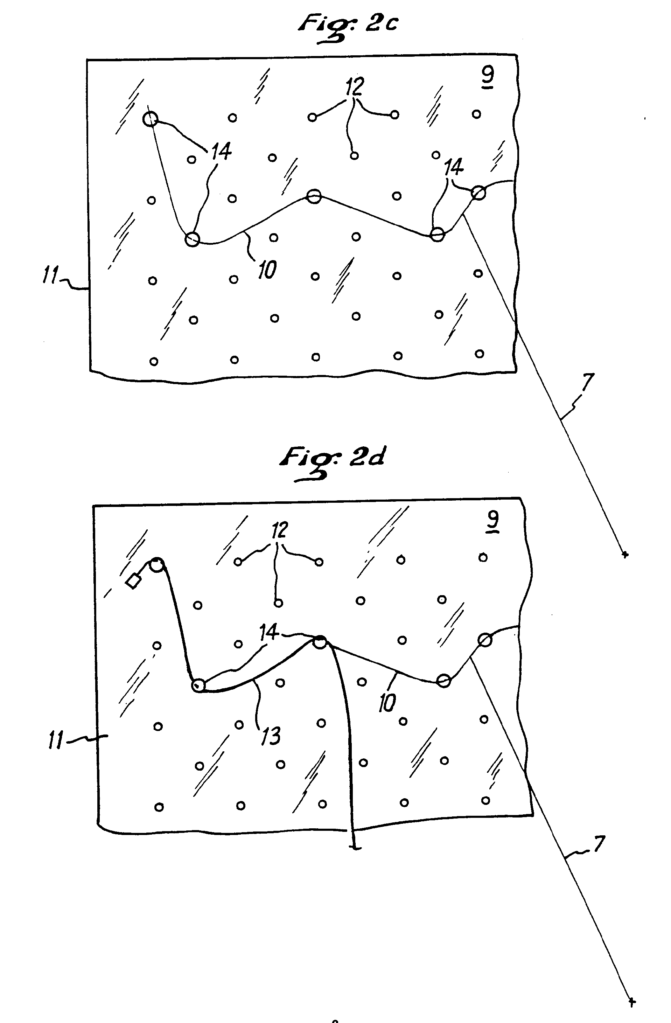

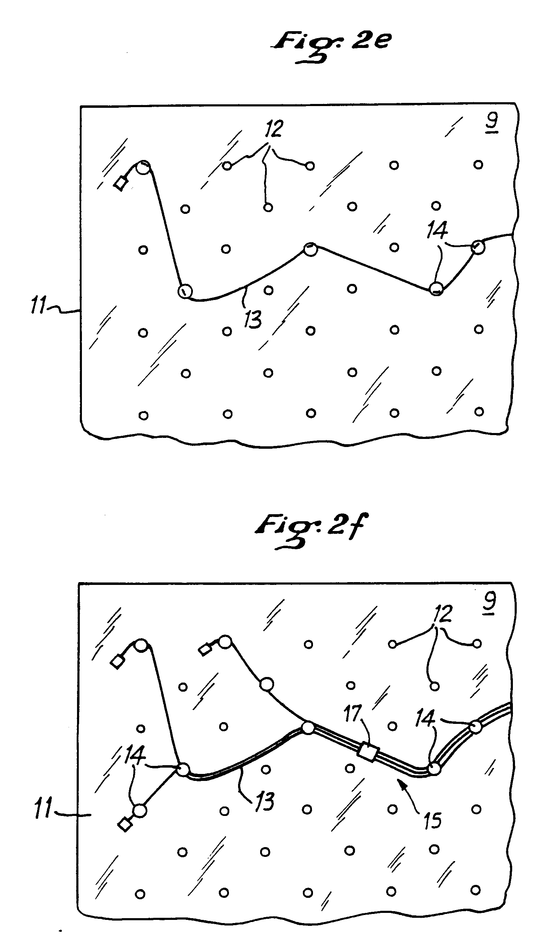

Une fois cette opération préliminaire achevée, et comme cela est montré sur la figure 2c, le générateur est commandé pour que le faisceau laser 7 balaye à grande vitesse le support 9 jouant le rôle d'écran, sur lequel apparaît le tracé lumineux du cheminement 10 du conducteur à mettre en place.

Le générateur de faisceau 2 est commandé par le micro-ordinateur 1 en fonction des informations concernant le cheminement spécifique du conducteur à mettre en place, stockées dans la mémoire 2, que ce soit pendant cette opération ou pendant l'opération préliminaire de mise en place des pions de guidage. Comme déjà indiqué, la grande vitesse de balayage permet d'obtenir une persistance optique du tracé lumineux.

La figure 2d montre le conducteur 13 en cours de mise en place à l'aide des pions de guidage 14, en suivant le cheminement 10 dont le tracé est continuellement affiché sur le support 9 formant écran.

Une fois achevée la mise en place d'un conducteur 13 (figure 2e), l'ensemble des opérations précédentes sera répété, de la même manière, pour tous les autres conducteurs, de façon à obtenir la pièce de câblage 15, bien évidemment simplifiée (par rapport à un cas réel) sur la figure 2f, pour des raisons de clarté du dessin, les conducteurs pouvant être réunis par des colliers ou des gaines de serrage 17.

Le système de l'invention permet de fournir à l'opérateur, de façon automatisée, toutes les informations qui lui sont nécessaires pour la mise en place, l'un après l'autre, des conducteurs d'une pièce de câblage, en mettant en oeuvre un micro-ordinateur, dont la mémoire contient toutes les informations concernant le cheminement de chaque conducteur de la pièce de câblage à réaliser, lequel pilote un générateur de faisceau laser qui signale, par une trace lumineuse sur un support formant écran, la position géographique des connecteurs de départ et d'arrivée, ainsi que la route que doit suivre chaque conducteur sélectionné par l'opérateur, et identifié grâce au lecteur de codes à barres.

## Revendications

1. Système pour la réalisation dans un plan d'une pièce de câblage, comportant une pluralité de conducteurs dont chacun doit suivre un cheminement prédéterminé, du type comportant:
- un support plan,
- des moyens de représentation de chacun desdits cheminements sur ledit support, et
- des moyens de maintien en place provisoire desdits conducteurs le long de leur cheminement,
lesdits moyens de représentation comprenant un générateur (6) d'un faisceau de lumière cohérente (7), pour lequel ledit support plan (9) joue le rôle d'écran, susceptible de balayer ledit support plan de façon à afficher, sur celui-ci, le tracé lumineux (10) du cheminement d'un conducteur déterminé (13) de ladite pièce, ledit système comportant de plus des moyens (2) pour mémoriser les informations relatives aux cheminements des différents conducteurs de la pièce de câblage, reliés, d'une part, à des moyens d'identification (4) d'un conducteur déterminé (13) et, d'autre part, à des moyens (1) pour commander ledit générateur de faisceau (6) pour afficher, sur ledit support, le cheminement (10) spécifique audit conducteur déterminé (13).

2. Système selon la revendication 1,
caractérisé en ce que ledit faisceau (7) balaye ledit support à une vitesse suffisamment grande pour obtenir une persistance optique dudit tracé (10).

3. Système selon l'une des revendications 1 ou 2, dans lequel lesdits moyens de maintien en place provisoire des conducteurs sont constitués de pions de guidage destinés à être insérés dans des trous prévus dans une plaque transparente recouvrant ledit support plan, caractérisé en ce que ledit générateur (6) peut être commandé de façon que ledit faisceau (7) désigne successivement une série déterminée de trous (12), dans lesquels doivent être insérés lesdits pions (14), en constituant ainsi une ébauche (16) de cheminement pour chacun desdits conducteurs.

4. Système selon l'une quelconque des revendications 1 à 3, caractérisé en ce que lesdits moyens d'identification sont constitués par un lecteur de codes à barres (4).

5. Système selon l'une quelconque des revendications 1 à 4, caractérisé en ce que ledit générateur est un générateur à laser (6) de faible puissance.

## Patentansprüche

1. System zur Herstellung eines Verdrahtungsteils auf einer Ebene, mit einer Vielzahl von Leitern, wovon jeder eine vorgegebene Strecke einhalten muß, des Typs mit:
- einem ebenen Träger,
- Mitteln zur Darstellung jeder der besagten Strecken auf dem besagten Träger, und
- Mitteln zum provisorischen Halten der besagten Leiter längs ihrer Strecke,
wobei die besagten Darstellungsmittel einen Generator (6) eines kohärenten Lichtbündels (7), für welchen der besagte ebene Träger (9) die Rolle eines Schirmes spielt,welcher den besagten ebenen Träger abtasten kann, um auf diesem die Lichtmarkierung (10) der Strecke eines bestimmten Leiters (13) des besagten Teilsanzuzeigen, enthalten, und das besagte System ausserdem Mittel (2) enthält zur Speicherung der Informationen bezüglich der Strecken der verschiedenen Leiter des Verdrahtungsteils, die einerseits mit Erkennungsmitteln (4) eines bestimmten Leiters (13) verbunden sind, und andererseits mit Mitteln (1) zur Steuerung des besagten Lichtbündelgenerators (6), um auf dem besagten Träger die spezifische Strecke (10) des bestimmten Leiters (13) anzuzeigen.

2. System nach dem Anspruch 1,
dadurch gekennzeichnet, daß das besagte Lichtbündel (7) den besagten Träger mit einer genügend großen Geschwindigkeit abtastet, um eine optische Beständigkeit der besagten Markierung (10) zu erhalten.

3. System nach einem der Ansprüche 1 oder 2, in welchem die besagten Mittel zum provisorischen Festhalten der Leiter aus Lenkstiften bestehen, die zum Einstecken in Löcher, die in einer durchsichtigen Platte, welche den ebenen Träger bedeckt, vorhanden sind, vorgesehen sind, dadurch gekennzeichnet, daß der besagte Generator (6) so gesteuert werden kann, daß das besagte Lichtbündel (7) nacheinander eine bestimmte Serie von Löchern (12) bezeichnet, in welche die besagten Stifte (14) eingesteckt werden sollen, wobei sie eine Streckenskizze (16) bilden für jeden der besagten Leiter.

4. System nach irgendeinem der Ansprüche 1 bis 3,
dadurch gekennzeichnet, daß die besagten Erkennungsmittel aus einem Strichcodeleser (4) bestehen.

5. System nach irgend einem der Ansprüche 1 bis 4,
dadurch gekennzeichnet, daß der besagte Generator ein Lasergenerator (6) mit kleiner Leistung ist.

## Claims

1. System for forming, in a plane, a wiring harness, comprising a plurality of conductors each of which must follow a predetermined routing, of the type comprising :
- a flat support,
- means for representing each of the said routings on the said support, and
- means for temporarily holding the said conductors in place along their routing,
the said representation means comprising a coherent light beam (7) generator (6), for which the said flat support (9) acts as a screen, capable of scanning the said flat support so as to display thereon the light trace (10) of the routing of a defined conductor (13) of the said harness, the said system further comprising means (2) for storing the information relating to the routings of the different conductors of the wiring harness, which means are connected on the one hand to means for identifying (4) a defined conductor (13) and, on the other hand, to means (1) for controlling the said beam generator (6) for displaying, on the said support, the routing (10) specific to the said defined conductor (13).

2. System according to Claim 1, characterised in that the said beam (7) scans the said support at a sufficiently high speed to obtain optical persistence of the said trace (10).

3. System according to Claim 1 or 2, in which the said means for temporarily holding the conductors in place consist of guide pins intended to be inserted into holes provided in a transparent plate covering the said flat support, characterised in that the said generator (6) may be controlled so that the said beam (7) successively designates a given series of holes (12) into which the said pins (14) must be inserted, thus forming a routing layout (16) for each of the said conductors.

4. System according to any one of Claims 1 to 3, characterised in that the said identification means consist of a bar code reader (4).

5. System according to any one of Claims 1 to 4, characterised in that the said generator is a low-power laser generator (6).
